# EUROPEAN PATENT SPECIFICATION

(11) **EP 4 261 554 B1**
(45) Date of publication and mention of the grant of the patent: **07.10.2026**
(21) Application number: 20965408.6
(22) Date of filing: 15.12.2020
(51) Int. Cl.: G01R 31/392, H01M 10/48, G01R 31/389, G01R 31/52

(54) **METHOD FOR DETECTING INTERNAL SHORT CIRCUIT OF BATTERY, ELECTRONIC DEVICE AND STORAGE MEDIUM**
VERFAHREN ZUR ERKENNUNG EINES INTERNEN KURZSCHLUSSES EINER BATTERIE, ELEKTRONISCHE VORRICHTUNG UND SPEICHERMEDIUM
PROCÉDÉ DE DÉTECTION DE COURT-CIRCUIT INTERNE D'UNE BATTERIE, DISPOSITIF ÉLECTRONIQUE ET SUPPORT DE STOCKAGE

(43) Date of publication of application: 18.10.2023
(73) Proprietor: Dongguan NVT Technology Limited, Donguan, Guangdong 523000 (CN)
(72) Inventor: LIU, Boyang, Dongguan, Guangdong 523000 (CN); WANG, Zhifeng, Dongguan, Guangdong 523000 (CN)
(74) Representative: Icosa
(86) International application number: PCT/CN2020/136585
(87) International publication number: WO 2022/126390

(56) References cited:
- EP-A1- 3 599 694
- CN-A- 107 192 914
- CN-A- 110 626 210
- CN-A- 110 764 015
- CN-A- 110 907 843
- CN-A- 111 198 327
- CN-A- 111 198 327
- CN-A- 111 208 439
- CN-A- 111 474 488
- US-A1- 2011 199 054

## Description

### TECHNICAL FIELD

This application relates to the technical field of batteries, and in particular, to a battery internal-short-circuit detection method, an electronic device, and a storage medium.

### BACKGROUND

Currently, a battery is prone to an internal short circuit for reasons such as: a separator of the battery is damaged, impurity particles are introduced during manufacturing of the battery, an electrode material of the battery is dissolved and deposited, dendrites are formed due to lithium plating on an electrode of the battery. The internal short circuit of the battery becomes severer over time. Consequently, the internal short circuit may cause the battery to burn or even explode, and damage life and property of the user. It is currently possible to determine occurrence of an internal short circuit in the battery by detecting the change in a terminal voltage of the battery that has been stored for a period in comparison with the terminal voltage of the battery prior to the storage. However, this method requires the battery to be in a state of absence of an external current for a long time, and is unable meet the requirement in an application scenario in which a portable electronic device is frequently charged and discharged.

EP 3 599 694 A1 discloses a battery internal short circuit detection method according to the preamble of claim 1.

### SUMMARY

In view of the situation above, it is necessary to provide a battery internal-short-circuit detection method, an electronic device, and a storage medium to determine, by detecting an internal short circuit resistance of a stand-alone battery during charging of the stand-alone battery, whether an internal short circuit exists in the battery.

This application provides a battery internal-short-circuit detection method according to claim 1.

According to some embodiments of this application, the obtaining a voltage difference ΔV generated across a charging time frame Δt during constant-current charging of the battery includes:
obtaining a voltage V₁ of the battery at a constant-current charging time point t₁;
obtaining a voltage V₂ of the battery at a constant-current charging time point t₂, where t₂ = t₁ + Δt; and
determining the voltage difference ΔV based on the voltage V₁ and the voltage V₂.

The obtaining a charge current I when the battery has been charged for the time frame Δt includes: obtaining a charge current I of the battery in a time frame from the time point t₁ to the time point t₂.

According to some embodiments of this application, the obtaining a battery-charging standard parameter includes: obtaining the battery-charging standard parameter that is obtained through an equivalent circuit model of the battery.

According to some embodiments of this application, before the obtaining a first standard voltage difference equation that includes a standard parameter equation of the battery, where the first standard voltage difference equation is obtained through the equivalent circuit model of the battery, the method further includes:
determining a standard equation of the equivalent circuit model of the battery based on a capacitance definition formula and a current definition formula;
determining, based on the standard equation of the equivalent circuit model of the battery, a second standard voltage difference equation generated when the battery has been charged for the time frame Δt; and
determining the first standard voltage difference equation based on the second standard voltage difference equation.

According to some embodiments of this application, the standard equation of the equivalent circuit model of the battery includes: ${V}_{standard} = {U}_{oc} + {U}_{s 0} {e}^{- \frac{t}{{R}_{s} {C}_{s}}} + {R}_{s} {I}_{standard} \left(1-{e}^{- \frac{t}{{R}_{s} {C}_{s}}}\right) + {I}_{standard} {R}_{0} .$

In the equation above, V_{standard} is a standard voltage of the battery, U_{oc} is an open circuit voltage of the battery, Uₛ₀ is an initial component voltage value of a polarization capacitor of the battery in a statically standing state, t is a charging time length of the battery, Rₛ is a polarizing internal resistance of the battery, Cₛ is a polarization capacitance of the battery, I_{standard} is a standard charge current of the battery, and R₀ is an ohmic internal resistance of the battery.

According to some embodiments of this application, the determining an internal short circuit resistance Rᵢ of the battery based on the battery-charging standard parameter, the voltage V₀, the voltage difference ΔV, and the charge current I includes:
determining a first equation of an equivalent circuit model of the battery based on a capacitance definition formula and a current definition formula;
determining, based on the first equation of the equivalent circuit model of the battery, a voltage difference equation generated when the battery has been charged for the time frame Δt; and
determining an internal short circuit resistance Rᵢ of the battery based on the voltage difference equation, the battery-charging standard parameter, the voltage V₀, the voltage difference ΔV, and the charge current I.

According to some embodiments of this application, the first equation of the equivalent circuit model of the battery includes: $V = {IR}_{s} + {IR}_{0} + {U}_{oc} - {R}_{s} \left(I-\frac{{U}_{s 0}}{{R}_{s}}+\frac{{V}_{0}}{{R}_{i}}\right) {e}^{- \frac{t}{{R}_{s} {C}_{s}}} .$

In the equation above, V is a voltage of the battery, I is the charge current when the battery has been charged for the time frame Δt, Rₛ is a polarizing internal resistance of the battery, R₀ is an ohmic internal resistance of the battery, U_{oc} is an open circuit voltage of the battery, Uₛ₀ is an initial component voltage value of a polarization capacitor of the battery in a statically standing state, V₀ is a voltage of the battery when the battery enters the constant-current charging phase, and Rᵢ is an internal short circuit resistance of the battery.

According to some embodiments of this application, the determining a first equation of an equivalent circuit model of the battery based on a capacitance definition formula and a current definition formula includes:
creating the equivalent circuit model of the battery;
determining a second equation of the equivalent circuit model of the battery based on the Ohm's law and the Kirchhoff's law; and
determining the first equation of the equivalent circuit model of the battery based on the capacitance definition formula, the current definition formula, and the second equation of the equivalent circuit model of the battery.

According to some embodiments of this application, the determining the first equation of the equivalent circuit model of the battery based on the capacitance definition formula, the current definition formula, and the second equation of the equivalent circuit model of the battery includes:
determining a differential equation of a component voltage of a polarization capacitor of the battery based on the capacitance definition formula and the current definition formula;
solving the differential equation of the component voltage of the polarization capacitor of the battery to determine a general solution to the component voltage of the polarization capacitor of the battery; and
determining the first equation of the equivalent circuit model of the battery based on the second equation of the equivalent circuit model of the battery and the general solution to the component voltage of the polarization capacitor of the battery.

According to some embodiments of this application, the differential equation of the component voltage of the polarization capacitor of the battery includes: ${C}_{s} \frac{{dU}_{s}}{dt} + \frac{{U}_{s}}{{R}_{s}} = I - \frac{V}{{R}_{i}} .$

In the equation above, Cₛ is a polarization capacitance of the battery, Uₛ is the component voltage of the polarization capacitor of the battery, Rₛ is a polarizing internal resistance of the battery, I is a charge current when the battery has been charged for the time frame Δt, V is a voltage of the battery, and Rᵢ is an internal-short-circuit resistance of the battery.

The general solution to the component voltage of the polarization capacitor of the battery includes: ${U}_{s} = \left({U}_{s 0}-\frac{{V}_{0}}{{R}_{i}}{R}_{s}\right) {e}^{- \frac{t}{{R}_{s} {C}_{s}}} + {R}_{s} \left(I-\frac{V}{{R}_{i}}\right) \left(1-{e}^{- \frac{t}{{R}_{s} {C}_{s}}}\right) .$

In the equation above, Uₛ is the component voltage of the polarization capacitor of the battery, Uₛ₀ is an initial component voltage value of the polarization capacitor of the battery in a statically standing state, V₀ is the voltage of the battery when the battery enters the constant-current charging phase, Rᵢ is the internal short circuit resistance of the battery, Rₛ is the polarizing internal resistance of the battery, t is a charging time length of the battery, Cₛ is the polarization capacitance of the battery, I is the charge current when the battery has been charged for the time frame Δt, and V is the voltage of the battery.

According to some embodiments of this application, before the determining an internal short circuit resistance Rᵢ of the battery based on the voltage difference equation, the battery-charging standard parameter, the voltage V₀, the voltage difference ΔV, and the charge current I, the method further includes: obtaining a standard parameter equation of the battery, where the standard parameter equation is obtained through the equivalent circuit model of the battery.

The determining an internal short circuit resistance Rᵢ of the battery based on the voltage difference equation, the battery-charging standard parameter, the voltage V₀, the voltage difference ΔV, and the charge current I includes:
determining an internal short circuit resistance equation of the battery based on the voltage difference equation and the standard parameter equation of the battery; and
determining the internal short circuit resistance Rᵢ of the battery based on the internal short circuit resistance equation of the battery, the battery-charging standard parameter, the voltage V₀, the voltage difference ΔV, and the charge current I.

According to some embodiments of this application, the battery-charging standard parameter includes a first battery-charging standard parameter and a second battery-charging standard parameter, and the internal short circuit resistance equation of the battery includes: ${R}_{i} = \frac{{V}_{0}}{\frac{ΔV}{α} - I + β} .$

In the equation above, Rᵢ is the internal short circuit resistance of the battery, V₀ is a voltage of the battery when the battery enters the constant-current charging phase, ΔV is the voltage difference generated across the charging time frame Δt during constant-current charging of the battery, α is the first battery-charging standard parameter, β is the second battery-charging standard parameter, and I is the charging current when the battery has been charged for the time frame Δt.

An embodiment of this application provides an electronic device. The electronic device includes:
a battery;
a processor; and
a memory, where the memory stores a plurality of program modules, and the plurality of program modules are loaded by the processor and execute the battery internal-short-circuit detection method according to any one of the embodiments described above.

An embodiment of this application provides a storage medium. The storage medium stores at least one computer instruction. The instruction is loaded by a processor to execute the battery internal-short-circuit detection method according to any one of the embodiments described above.

In the battery internal-short-circuit detection method, the electronic device, and the storage medium according to some embodiments of this application, the internal short circuit resistance Rᵢ of the battery is determined based on the battery-charging standard parameter, the voltage V₀, the voltage difference ΔV, and the charge current I, and whether an internal short circuit exists in the battery is determined based on the internal short circuit resistance Rᵢ of the battery. In this way, during charging of a stand-alone battery, whether an internal short circuit exists in the battery is determined by detecting the internal short circuit resistance of the stand-alone battery. The method satisfies an application scenario in which a portable electronic device is frequently charged and discharged.

### BRIEF DESCRIPTION OF DRAWINGS

FIG. 1 is a schematic diagram of an electronic device according to an embodiment of this application;
FIG. 2 is a flowchart of a battery internal-short-circuit detection method according to an embodiment of this application;
FIG. 3 is an equivalent circuit model of a battery when a standard parameter is obtained;
FIG. 4 is a flowchart of determining a battery-charging standard parameter in the battery internal-short-circuit detection method shown in FIG. 2;
FIG. 5 is a flowchart of determining a first standard voltage difference equation in the battery internal-short-circuit detection method shown in FIG. 2;
FIG. 6 is a schematic diagram of a relationship between a standard voltage difference and a standard charge current;
FIG. 7 is a flowchart of determining a battery internal-short-circuit resistance in the battery internal-short-circuit detection method shown in FIG. 2;
FIG. 8 is a flowchart of determining a first equation of an equivalent circuit model of a battery in the battery internal-short-circuit detection method shown in FIG. 2;
FIG. 9 is an equivalent circuit model of a battery for determining whether an internal short circuit exists in a battery; and
FIG. 10 shows how to determine a first equation of an equivalent circuit model of a battery in the battery internal-short-circuit detection method shown in FIG. 2.

### List of Reference Numerals:

| | |
|---|---|
| Electronic device | 100 |
| Memory | 11 |
| Processor | 12 |
| Battery | 13 |
| Acquisition device | 14 |
| Timer | 15 |

### DESCRIPTION OF EMBODIMENTS

The following clearly and thoroughly describes the technical solutions in some embodiments of this application with reference to the drawings appended hereto. Evidently, the described embodiments are merely a part of but not all of the embodiments of this application.

All other embodiments derived by a person of ordinary skill in the art based on the embodiments of the present invention without making any creative effort fall within the protection scope of the present invention.

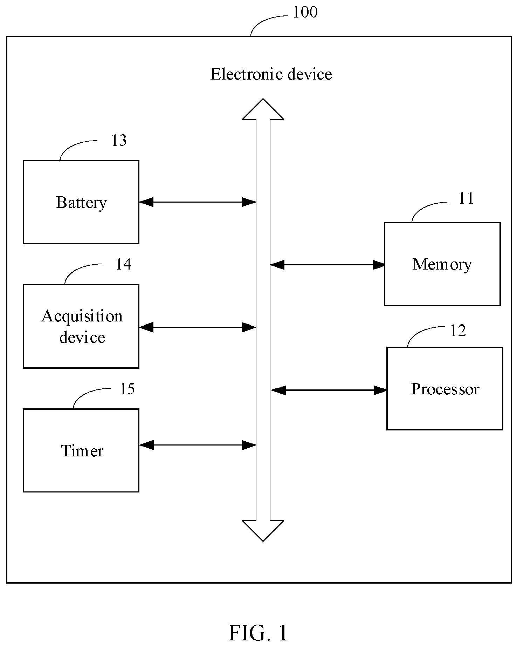

Referring to FIG. 1, FIG. 1 is a schematic diagram of an electronic device according to an embodiment of this application. The electronic device 100 includes, but is not limited to, a memory 11, at least one processor 12, a battery 13, an acquisition device 14, and a timer 15. Such components may be interconnected directly or by a bus.

It is hereby noted that FIG. 1 describes merely an example of the electronic device 100. In other embodiments, the electronic device 100 may include more or fewer components, or may include other different components. The electronic device 100 may be an electric motorcycle, an electric bicycle, an electric vehicle, a mobile phone, a tablet computer, a personal digital assistant, a personal computer, or any other rechargeable devices as appropriate.

In an embodiment, the battery 13 may be a rechargeable battery configured to provide electrical energy to the electronic device 100. For example, the battery 13 may be a lead-acid battery, a nickel-cadmium battery, a nickel-hydrogen battery, a lithium-ion battery, a lithium polymer battery, a lithium iron phosphate battery, or the like. The battery 13 is logically connected to the processor 12 through a battery management system (BMS), so that functions such as charging and discharging are implemented through the battery management system. The battery management system may be connected in communication with a power conversion system (PCS) through CAN or RS485. The battery 13 includes a battery cell. The battery is rechargeable cyclically.

In this embodiment, the acquisition device 14 is configured to acquire a voltage of the battery 13 and a charge current of the battery 13. In this embodiment, the acquisition device 14 is configured to acquire a voltage of the battery cell of the battery 13 and a charge current of the battery cell of the battery 13. In this embodiment, the acquisition device 14 is an analog-to-digital converter. Understandably, the acquisition device 14 may be another voltage acquisition device or current acquisition device instead. The timer 15 is configured to record a time length of charging the battery cell of the battery 13 in a charging process. Understandably, the electronic device 100 may further include other devices, such as a pressure sensor, a light sensor, a gyroscope, a hygrometer, an infrared sensor, and the like.

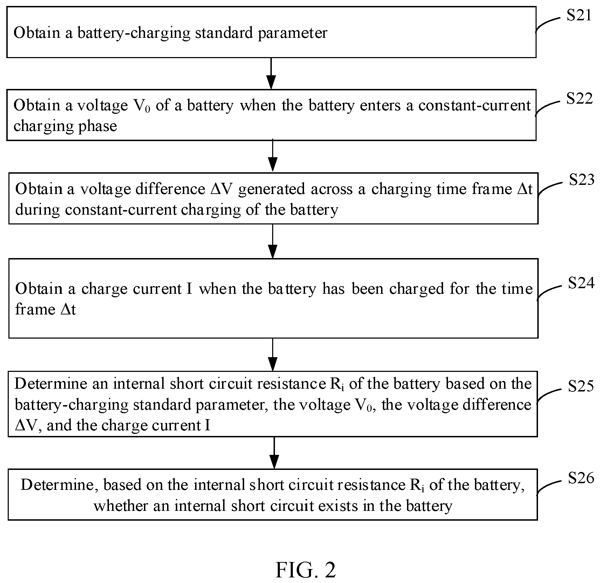

Referring to FIG. 2, FIG. 2 is a flowchart of a battery internal-short-circuit detection method according to an embodiment of this application. The battery internal-short-circuit detection method is applied to the battery. The battery internal-short-circuit detection method includes the following steps:
S21: Obtaining a battery-charging standard parameter.

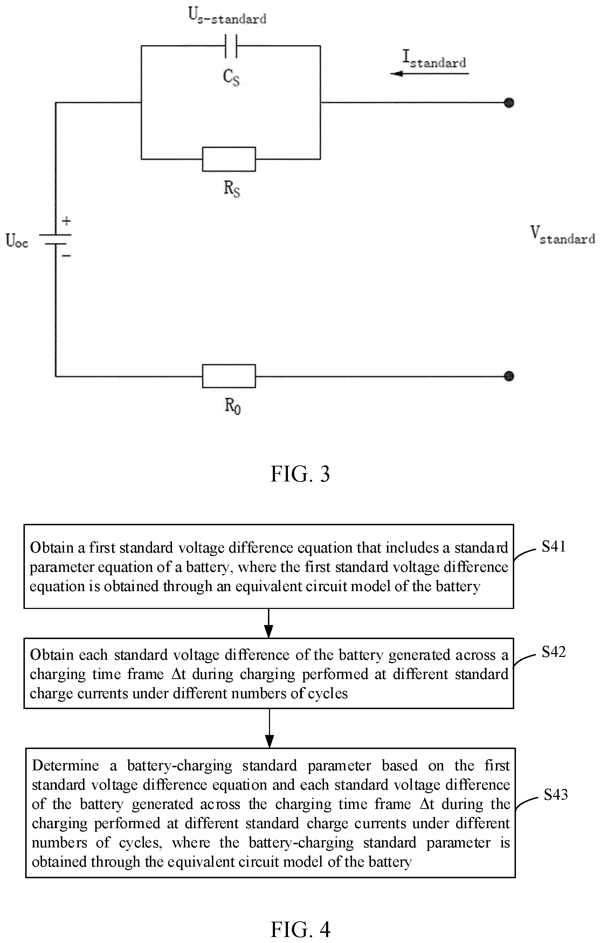

In this embodiment, the obtaining a battery-charging standard parameter includes: obtaining the battery-charging standard parameter that is obtained through an equivalent circuit model of the battery. The equivalent circuit model of the battery may be a Rint model, a Thevenin model, a PNGV model, a 2^{nd}-order RC model, or the like. In this embodiment, the battery equivalent circuit model is a Thevenin model. Referring to FIG. 3, FIG. 3 is an equivalent circuit model of a battery when a standard parameter is obtained. In FIG. 3, V_{standard} is a standard voltage of the battery, U_{oc} is an open circuit voltage of the battery, R₀ is an ohmic internal resistance of the battery, Rₛ is a polarizing internal resistance of the battery, Cₛ is a polarization capacitance of the battery, U_{s-standard} is a standard component voltage of a polarization capacitor of the battery, and I_{standard} is a standard charge current of the battery.

Referring to FIG. 4, the obtaining the battery-charging standard parameter that is obtained through an equivalent circuit model of the battery includes:
S41: Obtaining a first standard voltage difference equation that includes a standard parameter equation of the battery, where the first standard voltage difference equation is obtained through the equivalent circuit model of the battery.

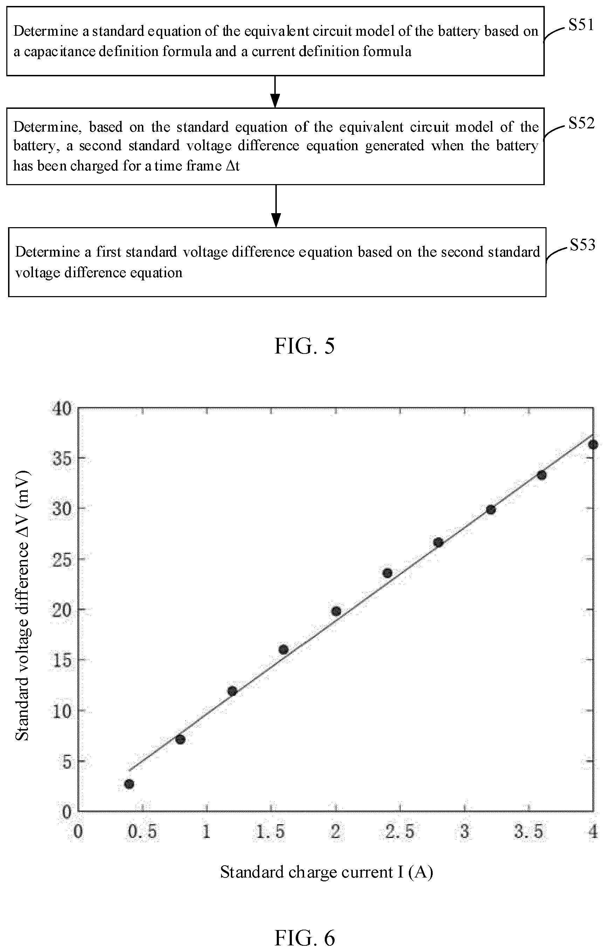

In this embodiment, referring to FIG. 5, before the obtaining a first standard voltage difference equation that includes a standard parameter equation of the battery, where the first standard voltage difference equation is obtained through the equivalent circuit model of the battery, the method further includes:
S51: Determining a standard equation of the equivalent circuit model of the battery based on a capacitance definition formula and a current definition formula.

The capacitance definition formula includes: ${U}_{s - standar} = \frac{Q}{{C}_{S}}$. In the formula above, *U_{s-standard}* is a standard component voltage of a polarization capacitor of the battery, Q is an amount of electric charge of the polarization capacitor of the battery, and *C_{S}* is a polarization capacitance of the battery. The current definition formula includes: ${I}_{1 - standard} = \frac{dQ}{dt}$. the formula above, *I*_{1*-standard*} is a standard charge current of the polarization capacitor of the battery, dQ is the amount of electric charge that passes through the polarization capacitor of the battery in a time frame, and *dt* is a time length spent by the electric charge in passing through the polarization capacitor of the battery.

The determining a standard equation of the equivalent circuit model of the battery based on a capacitance definition formula and a current definition formula includes the following steps:
a1: Creating the equivalent circuit model of the battery.

The equivalent circuit model of the battery is shown in FIG. 3. In this case, the battery is a standard battery, that is, a battery without an internal short circuit.

a2: Determining an equation of the equivalent circuit model of the battery based on the Ohm's law and the Kirchhoff s law.

The Ohm's law includes: *U*₀ *= I_{standard}* × *R*₀*.* In the equation above, *U*₀ is a voltage across an ohmic internal resistor of the battery, *I_{standard}* is a standard charge current that flows through the ohmic internal resistor of the battery, and *R*₀ is an ohmic internal resistance of the battery. The Kirchhoff s law includes: ${\sum }_{k = 1}^{m} {v}_{k} = 0$, where m is the number of components in a closed circuit in the equivalent circuit model of the battery, and *vₖ* is the voltage across the component.

The determining an equation of the equivalent circuit model of the battery based on the Ohm's law and the Kirchhoff s law includes:
b1: Determining a standard Kirchhoff voltage equation of the equivalent circuit model of the battery based on the Ohm's law.

The standard Kirchhoff voltage equation of the equivalent circuit model of the battery includes: *-V_{standard} + U_{s-standar} + U_{oc} + I_{standard}* × *R*₀ = 0. In the equation above, *V_{standard}* is a standard voltage of the battery, *U_{s-standard}* is a standard component voltage of the polarization capacitor of the battery, *U_{oc}* is an open circuit voltage of the battery, *I_{standard}* is a standard charge current of the battery, and *R*₀ is an ohmic internal resistance of the battery.

b2: Determining the equation of the equivalent circuit model of the battery based on the standard Kirchhoff voltage equation of the equivalent circuit model of the battery.

The equation of the equivalent circuit model of the battery includes: *V_{standard} = U_{oc} + U_{s-standard} + I_{standard}* × *R*₀*.* In the equation above, *V_{standard}* is the standard voltage of the battery, *U_{oc}* is the open circuit voltage of the battery, *U_{s-standar}* is the standard component voltage of the polarization capacitor of the battery, *I_{standard}* is the standard charge current of the battery, and *R*₀ is the ohmic internal resistance of the battery.

a3: Determining the standard equation of the equivalent circuit model of the battery based on the capacitance definition formula, the current definition formula, and the equation of the equivalent circuit model of the battery.

The determining the standard equation of the equivalent circuit model of the battery based on the capacitance definition formula, the current definition formula, and the equation of the equivalent circuit model of the battery includes:
c1: Determining a differential equation of a standard component voltage of a polarization capacitor of the battery based on the capacitance definition formula and the current definition formula.

The determining a differential equation of a standard component voltage of a polarization capacitor of the battery based on the capacitance definition formula and the current definition formula includes:
d1: Determining an equation of a standard charge current of the polarization capacitor of the battery based on the capacitance definition formula and the current definition formula.

The equation of the standard charge current of the polarization capacitor of the battery includes: ${I}_{1 - standard} = \frac{dQ}{dt} = \frac{{dU}_{s} \times {C}_{S}}{dt} = {C}_{S} \frac{{dU}_{s}}{dt}$. In the equation above, *I*_{1*-standar*} is the standard charge current of the polarization capacitor of the battery, *dQ* is the amount of electric charge that passes through the polarization capacitor of the battery in a time frame *dt, dt* is a time length spent by the electric charge in passing through the polarization capacitor of the battery, *U_{s-standar}* is the standard component voltage of the polarization capacitor of the battery, and *C_{S}* is the polarization capacitance of the battery.

d2: Determining a differential equation of the standard component voltage of the polarization capacitor of the battery based on the equation of the charge current of the polarization capacitor of the battery.

The differential equation of the standard component voltage of the polarization capacitor of the battery includes: ${I}_{standard} = {I}_{1 - standar} + {I}_{2} = {C}_{S} \frac{{dU}_{s - standard}}{dt} + \frac{{U}_{s - standard}}{{R}_{s}}$ . That is, the differential equation of the standard component voltage of the polarization capacitor of the battery includes: ${C}_{S} \frac{{dU}_{s - standard}}{dt} + \frac{{U}_{s - standar}}{{R}_{s}} = {I}_{standard}$. In the equation above, *Cₛ* is the polarization capacitance of the battery, *dU_{s-standard}* is the standard voltage that runs across the polarization capacitor of the battery in a time frame, *dt* is the time length spent by the electric charge in passing through the polarization capacitor of the battery, *U_{s-standard}* is the standard component voltage of the polarization capacitor of the battery, *Rₛ* is the polarizing internal resistance of the battery, and *I_{standard}* is the standard charge current of the battery.

c2: Solving the differential equation of the standard component voltage of the polarization capacitor of the battery to determine a general solution to the standard component voltage of the polarization capacitor of the battery.

The general solution to the standard component voltage of the polarization capacitor of the battery includes: ${U}_{s - standard} = {U}_{s 0} {e}^{- \frac{t}{{R}_{s} {C}_{s}}} + {R}_{s} {I}_{standard} \left(1-{e}^{- \frac{t}{{R}_{s} {C}_{s}}}\right) .$*.* In the equation above, *U_{s-standar}* is the standard component voltage of the polarization capacitor of the battery, *U*_{*s*0} is the initial component voltage value of the polarization capacitor of the battery in a statically standing state, *t* is the charging time length of the battery, Rₛ is the polarizing internal resistance of the battery, *Cₛ* is the polarization capacitance of the battery, *I_{standard}* is the standard charge current of the battery.

c3: Determining the standard equation of the equivalent circuit model of the battery based on the equation of the equivalent circuit model of the battery and the general solution to the standard component voltage of the polarization capacitor of the battery.

The standard equation of the equivalent circuit model of the battery includes: ${V}_{standard} = {U}_{oc} + {U}_{s - standard} + {I}_{standard} \times {R}_{0} = {U}_{oc} + {U}_{s 0} {e}^{- \frac{t}{{R}_{s} {C}_{s}}} +$ ${R}_{s} {I}_{standard} \left(1-{e}^{- \frac{t}{{R}_{s} {C}_{s}}}\right) + {I}_{standard} {R}_{0}$. That is, the standard equation of the equivalent circuit model of the battery includes: ${V}_{standard} = {U}_{oc} + {U}_{s 0} {e}^{- \frac{t}{{R}_{s} {C}_{s}}} + {R}_{s} {I}_{standard} \left(1-{e}^{- \frac{t}{{R}_{s} {C}_{s}}}\right) + {I}_{standard} {R}_{0}$ *.* In the equation above, *V_{standard}* is the standard voltage of the battery, *U_{oc}* is the open circuit voltage of the battery, *U_{s-standard}* is the standard component voltage the polarization capacitor of the battery, *I_{standard}* is the standard charge current of the battery, *R*₀ is the ohmic internal resistance of the battery, *U*_{*s*0} is the initial component voltage value of the polarization capacitor of the battery in a statically standing state, *t* is the charging time length of the battery, Rₛ is the polarizing internal resistance of the battery, and *Cₛ* is the polarization capacitance of the battery.

S52: Determining, based on the standard equation of the equivalent circuit model of the battery, a second standard voltage difference equation generated when the battery has been charged for the time frame Δt.

The second standard voltage difference equation includes: $Δ {V}_{standard} =$ $\left({U}_{oc}+{U}_{s 0}{e}^{- \frac{{t}_{2}}{{R}_{s} {C}_{s}}}+{R}_{s}{I}_{standard}\left(1-{e}^{- \frac{{t}_{2}}{{R}_{s} {C}_{s}}}\right)+{I}_{standard}{R}_{0}\right) - \left({U}_{oc}+{U}_{s 0}{e}^{- \frac{{t}_{1}}{{R}_{s} {C}_{s}}}\right. +$ $\left.{R}_{s}{I}_{standard}\left(1-{e}^{- \frac{{t}_{1}}{{R}_{s} {C}_{s}}}\right)+{I}_{standard}{R}_{0}\right) = \left({R}_{s}{I}_{standard}-{U}_{s 0}\right) \left({e}^{- \frac{{t}_{1}}{{R}_{s} {C}_{s}}}-{e}^{- \frac{{t}_{2}}{{R}_{s} {C}_{s}}}\right)$. That is, the second standard voltage difference equation includes: $Δ {V}_{standard} = \left({R}_{s}{I}_{standard}-{U}_{s 0}\right) \left({e}^{- \frac{{t}_{1}}{{R}_{s} {C}_{s}}}-{e}^{- \frac{{t}_{2}}{{R}_{s} {C}_{s}}}\right)$ *.* In the equation above, *t*₂ *= t*₁ + Δ*t,* Δ*V_{standard}* is the standard voltage difference generated when the battery has been charged for the time frame Δ*t*, *U_{oc}* is the open circuit voltage of the battery, *U*_{*s*0} is the initial component voltage value of the polarization capacitor of the battery in a statically standing state, *t*₁ is the first constant-current charging time point, Rₛ is the polarizing internal resistance of the battery, *Cₛ* is the polarization capacitor of the battery, *I_{standard}* is the standard charge current when the battery has been charged for the time frame Δ*t*, *R*₀ is the ohmic internal resistance of the battery, and *t*₂ is the second constant-current charging time point.

S53: Determining the first standard voltage difference equation based on the second standard voltage difference equation.

The first standard voltage difference equation includes: $Δ {V}_{standard} = \left({R}_{s}{I}_{standard}-{U}_{s 0}\right) \left({e}^{- \frac{{t}_{1}}{{R}_{s} {C}_{s}}}-{e}^{- \frac{{t}_{2}}{{R}_{s} {C}_{s}}}\right) = {R}_{s} {I}_{standard} \left({e}^{- \frac{{t}_{1}}{{R}_{s} {C}_{s}}}-{e}^{- \frac{{t}_{2}}{{R}_{s} {C}_{s}}}\right) -$ ${U}_{s 0} \left({e}^{- \frac{{t}_{1}}{{R}_{s} {C}_{s}}}-{e}^{- \frac{{t}_{2}}{{R}_{s} {C}_{s}}}\right) = {R}_{s} {I}_{standard} \left({e}^{- \frac{{t}_{1}}{{R}_{s} {C}_{s}}}-{e}^{- \frac{{t}_{2}}{{R}_{s} {C}_{s}}}\right) - \frac{{U}_{s 0}}{{R}_{s}} {R}_{s} \left({e}^{- \frac{{t}_{1}}{{R}_{s} {C}_{s}}}-{e}^{- \frac{{t}_{2}}{{R}_{s} {C}_{s}}}\right) =$ ${αI}_{standard} - αβ$*.* That is, the first standard voltage difference equation includes: *ΔV_{standard}* = *αI_{standard} - αβ.* In the equation above, $α = {R}_{s} \left({e}^{- \frac{{t}_{1}}{{R}_{s} {C}_{s}}}-{e}^{- \frac{{t}_{2}}{{R}_{s} {C}_{s}}}\right)$*,* and $β = \frac{{U}_{s 0}}{{R}_{s}}$*.* The formula $α = {R}_{s} \left({e}^{- \frac{{t}_{1}}{{R}_{s} {C}_{s}}}-{e}^{- \frac{{t}_{2}}{{R}_{s} {C}_{s}}}\right)$ and the formula $β = \frac{{U}_{s 0}}{{R}_{s}}$ are standard parameter equations of the battery.

In the equations above, t₂ = t₁ + Δt, ΔV_{standard} is the standard voltage difference generated when the battery has been charged for the time frame Δt, Rₛ is the polarizing internal resistance of the battery, *I_{standard}* is the standard charge current when the battery has been charged for the time frame Δt, Uₛ₀ is the initial component voltage value of the polarization capacitor of the battery in a statically standing state, t₁ is a first constant-current charging time point, t₂ is a second constant-current charging time point, Cₛ is the polarization capacitance of the battery, α is the first battery-charging standard parameter, and β is the second battery-charging standard parameter.

S42: Obtaining each standard voltage difference of the battery generated across the charging time frame Δt during the charging performed at different standard charge currents under different numbers of cycles.

The obtaining each standard voltage difference of the battery generated across the charging time frame Δt during the charging performed at different standard charge currents under different numbers of cycles may be, for example, obtaining the standard voltage difference of the battery generated from the 1^{st} second to the 11^{th} second during the constant-current charging performed at a constant current of 0.4 A, 0.8 A, 1.2 A, 1.6 A, 2 A, 2.4 A, 2.8 A, 3.2 A, 3.6 A, and 4 A respectively under different numbers of cycles after the battery is discharged at a current of 0.8 A until a cut-off voltage.

S43: Determining the battery-charging standard parameter based on the first standard voltage difference equation and each standard voltage difference of the battery generated across the charging time frame Δt during the charging performed at different standard charge currents under different numbers of cycles, where the battery-charging standard parameter is obtained through the equivalent circuit model of the battery.

Referring to FIG. 6, FIG. 6 is a schematic diagram of a relationship between a standard voltage difference and a standard charge current. In FIG. 6, scattered points formed by the standard voltage difference and the standard charge current are arranged on roughly the same straight line. In this embodiment, for example, in FIG. 6, the first battery-charging standard parameter and the second battery-charging standard parameter are determined to be 9.2271 and 0.0411 respectively based on the first standard voltage difference equation and each standard voltage difference of the battery generated across the charging time frame Δt during the charging performed at different standard charge currents under different numbers of cycles, where the battery-charging standard parameters are obtained through the equivalent circuit model of the battery.

S22: Obtaining a voltage V₀ of a battery when the battery enters a constant-current charging phase.

In this embodiment, an acquisition device obtains the voltage V₀ of the battery when the battery enters a constant-current charging phase.

The battery at this time, and a battery corresponding to the obtained battery attribute to be described below, and a battery corresponding to the determined battery attribute, may be a battery for which the battery-charging standard parameter is determined and a battery that may incur an internal short circuit over time, for example, a battery for which the battery-charging standard parameter is determined and which has been used for 6 months, that is, a battery identical to the battery for which the battery-charging standard parameter is determined. Alternatively, the battery at this time, and a battery corresponding to the obtained battery attribute to be described below, and a battery corresponding to the determined battery attribute, may be a battery of which an internal short circuit is to be determined, that is, a battery different from the battery for which the battery-charging standard parameter is determined.

S23. Obtaining a voltage difference ΔV generated across a charging time frame Δt during constant-current charging of the battery.

In this embodiment, the obtaining a voltage difference ΔV generated across a charging time frame Δt during constant-current charging of the battery includes:
e1: Obtaining a voltage V₁ of the battery at a constant-current charging time point t₁;
e2: Obtaining a voltage V₂ of the battery at a constant-current charging time point t₂, where t₂ = t₁ + Δt; and
e3: Determining the voltage difference ΔV based on the voltage V₁ and the voltage V₂.
S24: Obtaining a charge current I when the battery has been charged for the time frame Δt.

The obtaining a charge current I when the battery has been charged for the time frame Δt includes: obtaining a charge current I of the battery in a time frame from the time point t₁ to the time point t₂.

S25: Determining an internal short circuit resistance Rᵢ of the battery based on the battery-charging standard parameter, the voltage V₀, the voltage difference ΔV, and the charge current I.

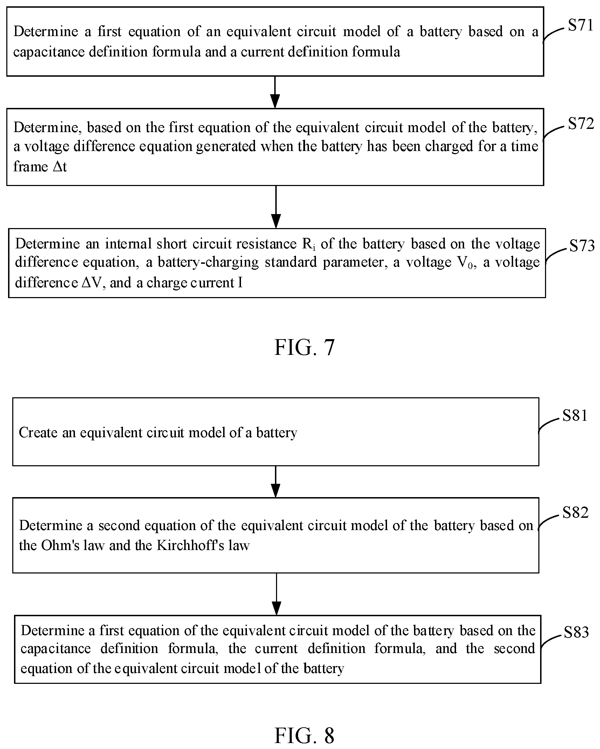

Referring to FIG. 7, the determining an internal short circuit resistance Rᵢ of the battery based on the battery-charging standard parameter, the voltage V₀, the voltage difference ΔV, and the charge current I includes the following steps:
S71: Determining a first equation of an equivalent circuit model of the battery based on a capacitance definition formula and a current definition formula.

The capacitance definition formula includes: ${U}_{s} = \frac{Q}{{C}_{s}}$. In the formula above, *Uₛ* is a component voltage of a polarization capacitor of the battery, *Q* is an amount of electric charge of the polarization capacitor of the battery, and *C_{S}* is a polarization capacitance of the battery. The current definition formula includes: ${I}_{1} = \frac{dQ}{dt}$. In the formula above, *I*₁ is a charge current of the polarization capacitor of the battery, dQ is the amount of electric charge that passes through the polarization capacitor of the battery in a time frame, and *dt* is a time length spent by the electric charge in passing through the polarization capacitor of the battery.

Referring to FIG. 8, the determining a first equation of an equivalent circuit model of the battery based on a capacitance definition formula and a current definition formula includes the following steps:
S81: Creating the equivalent circuit model of the battery.

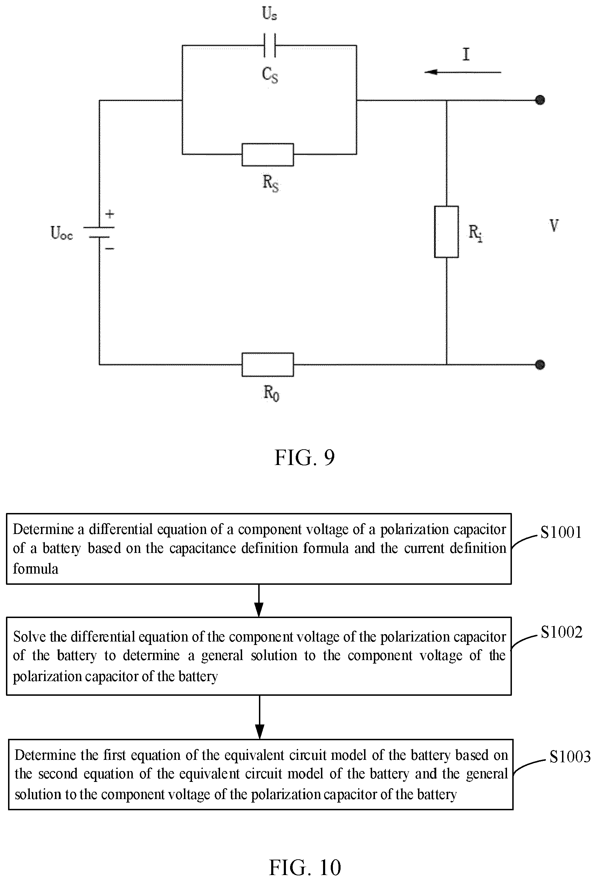

The equivalent circuit model of the battery is shown in FIG. 9. At this time, an internal short circuit may exist in the battery. In FIG. 9, V is the voltage of the battery, U_{oc} is the open circuit voltage of the battery, R₀ is the ohmic internal resistance of the battery, Rₛ is the polarizing internal resistance of the battery, Cₛ is the polarization capacitance of the battery, Uₛ is the component voltage of the polarization capacitor of the battery, I is the charge current of the battery, and Rᵢ is the internal short circuit resistance of the battery.

S82: Determining a second equation of the equivalent circuit model of the battery based on the Ohm's law and the Kirchhoff's law.

The Ohm's law includes: *U*₀ *= I* × *R*₀*.* In the equation above, *U*₀ is a voltage across an ohmic internal resistor of the battery, *I* is a charge current that flows through the ohmic internal resistor of the battery, and *R*₀ is an ohmic internal resistance of the battery. The Kirchhoff's law includes: ${\sum }_{k = 1}^{m} {v}_{k} = 0$, where *m* is the number of components in a closed circuit in the equivalent circuit model of the battery, and *vₖ* is the voltage across the component.

The determining a second equation of the equivalent circuit model of the battery based on the Ohm's law and the Kirchhoff's law includes:
f1: Determining a Kirchhoff voltage equation of the equivalent circuit model of the battery based on the Ohm's law.

The Kirchhoff voltage equation of the equivalent circuit model of the battery includes: $- V + {U}_{s} + {U}_{oc} + \left(I-\frac{V}{{R}_{i}}\right) \times {R}_{0} = 0$. In the equation above, *V* is the voltage of the battery, *Uₛ* is the component voltage of the polarization capacitor of the battery, *U_{oc}* is the open circuit voltage of the battery, *I* is the charge current of the battery, *Rᵢ* is the internal short circuit resistance of the battery, and *R*₀ is an ohmic internal resistance of the battery.

f2: Determining the second equation of the equivalent circuit model of the battery based on the Kirchhoff voltage equation of the equivalent circuit model of the battery.

The second equation of the equivalent circuit model of the battery includes: $V = {U}_{oc} + {U}_{s} + \left(I-\frac{V}{{R}_{i}}\right) \times {R}_{0}$. In the equation above, *V* is the voltage of the battery, *U_{oc}* is the open circuit voltage of the battery, *Uₛ* is the component voltage of the polarization capacitor of the battery, *I* is the charge current of the battery, *Rᵢ* is the internal short circuit resistance of the battery, and *R*₀ is the ohmic internal resistance of the battery.

S83: Determining the first equation of the equivalent circuit model of the battery based on the capacitance definition formula, the current definition formula, and the second equation of the equivalent circuit model of the battery.

Referring to FIG. 10, the determining the first equation of the equivalent circuit model of the battery based on the capacitance definition formula, the current definition formula, and the second equation of the equivalent circuit model of the battery includes the following step:
S1001: Determining a differential equation of a component voltage of a polarization capacitor of the battery based on the capacitance definition formula and the current definition formula.

The determining a differential equation of a component voltage of a polarization capacitor of the battery based on the capacitance definition formula and the current definition formula includes the following steps:
g1: Determining an equation of a charge current of the polarization capacitor of the battery based on the capacitance definition formula and the current definition formula.

The equation of the charge current of the polarization capacitor of the battery includes: ${I}_{1} = \frac{dQ}{dt} = \frac{{dU}_{s} \times {C}_{S}}{dt} = {C}_{S} \frac{{dU}_{s}}{dt}$*.* In the equation above, *I*₁ is the charge current of the polarization capacitor of the battery, *dQ* is the amount of electric charge that passes through the polarization capacitor of the battery in a time frame *dt, dt* is a time length spent by the electric charge in passing through the polarization capacitor of the battery, *Uₛ* is the component voltage of the polarization capacitor of the battery, and *C_{S}* is the polarization capacitance of the battery.

g2: Determining a differential equation of the component voltage of the polarization capacitor of the battery based on the equation of the charge current of the polarization capacitor of the battery.

The differential equation of the component voltage of the polarization capacitor of the battery includes: $I - \frac{V}{{R}_{i}} = {I}_{1} + {I}_{2} = {C}_{S} \frac{{dU}_{s}}{dt} + \frac{{U}_{s}}{{R}_{s}}$. That is, the differential equation of the component voltage of the polarization capacitor of the battery includes: ${C}_{S} \frac{{dU}_{s}}{dt} + \frac{{U}_{s}}{{R}_{s}} = I - \frac{V}{{R}_{i}}$*.* In the equation above, *Cₛ* is the polarization capacitance of the battery, *dUₛ* is the voltage that runs across the polarization capacitor of the battery in a time frame, *dt* is the time length spent by the electric charge in passing through the polarization capacitor of the battery, *Uₛ* is the component voltage of the polarization capacitor of the battery, *Rₛ* is the polarizing internal resistance of the battery, *I* is the charge current of the battery, *V* is the voltage of the battery, and *Rᵢ* is the internal short circuit resistance of the battery.

S1002: Solving the differential equation of the component voltage of the polarization capacitor of the battery to determine a general solution to the component voltage of the polarization capacitor of the battery.

The general solution to the component voltage of the polarization capacitor of the battery includes: ${U}_{s} = \left({U}_{s 0}-\frac{{V}_{0}}{{R}_{i}}{R}_{s}\right) {e}^{- \frac{t}{{R}_{s} {C}_{s}}} + {R}_{s} \left(I-\frac{V}{{R}_{i}}\right) \left(1-{e}^{- \frac{t}{{R}_{s} {C}_{s}}}\right)$*.* In the equation above, *Uₛ* is the component voltage of the polarization capacitor of the battery, *U*_{*s*0} is the initial component voltage value of the polarization capacitor of the battery in a statically standing state, *V*₀ is the voltage of the battery when the battery enters the constant-current charging phase, *Rᵢ* is the internal short circuit resistance of the battery, Rₛ is the polarizing internal resistance of the battery, *t* is the charging time length of the battery, *Cₛ* is the polarization capacitance of the battery, *I* I is the charge current when the battery has been charged for the time frame Δ*t*, and *V* is the voltage of the battery.

S1003: Determining the first equation of the equivalent circuit model of the battery based on the second equation of the equivalent circuit model of the battery and the general solution to the component voltage of the polarization capacitor of the battery.

The second equation of the equivalent circuit model of the battery includes: $V = {U}_{oc} + {U}_{s} + \left(I-\frac{V}{{R}_{i}}\right) \times {R}_{0} = {U}_{oc} + \left({U}_{s 0}-\frac{{V}_{0}}{{R}_{i}}{R}_{s}\right) {e}^{- \frac{t}{{R}_{s} {C}_{s}}} + {R}_{s} \left(I-\frac{V}{{R}_{i}}\right) \left(1-\right.$ $\left.{e}^{- \frac{t}{{R}_{s} {C}_{s}}}\right) + \left(I-\frac{V}{{R}_{i}}\right) {R}_{0}$*.* The internal short circuit resistance is much greater than the ohmic internal resistance and the polarizing internal resistance of the battery. Therefore, $\frac{{R}_{0}}{{R}_{i}} \approx 0$, and $\frac{{R}_{s}}{{R}_{i}} \approx 0$. In addition, the purpose of this application is to determine whether an internal short circuit exists in the battery. Therefore, the value of $\frac{{V}_{0}}{{R}_{i}} {R}_{s}$ is not ignorable. Therefore, the first equation of the equivalent circuit model of the battery includes: $V = {IR}_{s} + {IR}_{0} + {U}_{oc} - {R}_{s} \left(I-\frac{{U}_{s 0}}{{R}_{s}}+\frac{{V}_{0}}{{R}_{i}}\right) {e}^{- \frac{t}{{R}_{s} {C}_{s}}}$. In the equation above, *V* is the voltage of the battery, *I* is the charge current when the battery has been charged for the time frame Δ*t*, Rₛ is the polarizing internal resistance of the battery, *R*₀ is the ohmic internal resistance of the battery, *U_{oc}* is the open circuit voltage of the battery, *U*_{*s*0} is the initial component voltage value of the polarization capacitor of the battery in a statically standing state, *V*₀ is the voltage of the battery when the battery enters the constant-current charging phase, and *Rᵢ* is the internal short circuit resistance of the battery.

S72: Determining, based on the first equation of the equivalent circuit model of the battery, a voltage difference equation generated when the battery has been charged for the time frame Δt.

The voltage difference equation includes: $Δ V = \left({IR}_{s}+{IR}_{0}+{U}_{oc}-\right.$ ${R}_{s} \left(I-\frac{{U}_{s 0}}{{R}_{s}}+\frac{{V}_{0}}{{R}_{i}}\right) \left.{e}^{- \frac{{t}_{2}}{{R}_{s} {C}_{s}}}\right) - \left({IR}_{s}+{IR}_{0}+{U}_{oc}-{R}_{s}\left(I-\frac{{U}_{s 0}}{{R}_{s}}+\frac{{V}_{0}}{{R}_{i}}\right){e}^{- \frac{{t}_{1}}{{R}_{s} {C}_{s}}}\right) = \left(I-\right.$ $\left.\frac{{U}_{s 0}}{{R}_{s}}+\frac{{V}_{0}}{{R}_{i}}\right) {R}_{s} \left({e}^{- \frac{{t}_{1}}{{R}_{s} {C}_{s}}}-{e}^{- \frac{{t}_{2}}{{R}_{s} {C}_{s}}}\right)$. In the equation above, *t*₂ = *t*₁ + Δ*t.* Δ*V* is the voltage difference generated when the battery has been charged for the time frame Δ*t*, *I* is the charge current when the battery has been charged for the time frame Δ*t*, Rₛ is the polarizing internal resistance of the battery, *R*₀ is the ohmic internal resistance of the battery, *U_{oc}* is the open circuit voltage of the battery, *U*_{*s*0} is the initial component voltage value of the polarization capacitor of the battery in a statically standing state, *V*₀ is the voltage of the battery when the battery enters the constant-current charging phase, *Rᵢ* is the internal short circuit resistance of the battery, *t*₂ is the second constant-current charging time point, *Cₛ* is the polarization capacitance of the battery, and *t*₁ is the first constant-current charging time point.

S73: Determining an internal short circuit resistance Rᵢ of the battery based on the voltage difference equation, the battery-charging standard parameter, the voltage V₀, the voltage difference ΔV, and the charge current I.

Before the determining an internal short circuit resistance Rᵢ of the battery based on the voltage difference equation, the battery-charging standard parameter, the voltage V₀, the voltage difference ΔV, and the charge current I, the method further includes: obtaining a standard parameter equation of the battery, where the standard parameter equation is obtained through the equivalent circuit model of the battery.

The standard parameter equation of the battery includes: $α = {R}_{s} \left({e}^{- \frac{{t}_{1}}{{R}_{s} {C}_{s}}}-{e}^{- \frac{{t}_{2}}{{R}_{s} {C}_{s}}}\right)$ , and $β = \frac{{U}_{s 0 - standard}}{{R}_{s}}$. In the equations above, α is the first battery-charging standard parameter, Rₛ is the polarizing internal resistance of the battery, *t*₁ is the first constant-current charging time point, *Cₛ* is the polarization capacitance of the battery, *t*₂ is the second constant-current charging time point, *β* is the second battery-charging standard parameter, and *U*_{*s*0} is the initial component voltage value of the polarization capacitor of the battery in a statically standing state.

The determining an internal short circuit resistance Rᵢ of the battery based on the voltage difference equation, the battery-charging standard parameter, the voltage V₀, the voltage difference ΔV, and the charge current I includes the following steps:

h1: Determining an internal short circuit resistance equation of the battery based on the voltage difference equation and the standard parameter equation of the battery.

The voltage difference equation includes: $Δ V = \left(I-\frac{{U}_{s 0}}{{R}_{s}}+\frac{{V}_{0}}{{R}_{i}}\right) {R}_{s} \left({e}^{- \frac{{t}_{1}}{{R}_{s} {C}_{s}}}-{e}^{- \frac{{t}_{2}}{{R}_{s} {C}_{s}}}\right) = α \left(I-β+\frac{{V}_{0}}{{R}_{i}}\right)$ , and therefore, $\frac{Δ V}{α} = \left(I-β+\frac{{V}_{0}}{{R}_{i}}\right)$. Therefore, the internal short circuit resistance equation of the battery includes: ${R}_{i} = \frac{{V}_{0}}{\frac{ΔV}{α} - I + β}$ . In the equation above, Δ*V* is the voltage difference generated when the battery has been charged for the time frame Δ*t*, *I* is the charge current when the battery has been charged for the time frame Δ*t*, *U*_{*s*0} is the initial component voltage value of the polarization capacitor of the battery in a statically standing state, Rₛ is the polarizing internal resistance of the battery, V₀ is the voltage of the battery when the battery enters the constant-current charging phase, *Rᵢ* is the internal short circuit resistance of the battery, *t*₁ is the first constant-current charging time point, *Cₛ* is the polarization capacitance of the battery, *t*₂ is the second constant-current charging time point, *α* is the first battery-charging standard parameter, and *β* is the second battery-charging standard parameter.

h2: Determining the internal short circuit resistance Rᵢ of the battery based on the internal short circuit resistance equation of the battery, the battery-charging standard parameter, the voltage V₀, the voltage difference ΔV, and the charge current I.

In this embodiment, the internal short circuit resistance Rᵢ of the battery is determined by substituting the battery-charging standard parameter, the voltage V₀, the voltage difference ΔV, and the charge current I into the internal short circuit resistance equation of the battery.

S26: Determining, based on the internal short circuit resistance Rᵢ of the battery, whether an internal short circuit exists in the battery.

In this embodiment, based on the internal short circuit resistance Rᵢ of the battery and a first preset short circuit resistance, it is determined whether an internal short circuit exists in the battery. Preferably, the first preset short circuit resistance may be 600 ohms, or other values such as 500 ohms or 700 ohms, depending on specific needs. The determining, based on the internal short circuit resistance Rᵢ of the battery, whether an internal short circuit exists in the battery includes:
determining, if the internal short circuit resistance Rᵢ of the battery is greater than or equal to the first preset short circuit resistance, that no internal short circuit exists in the battery; and
determining, if the internal short circuit resistance Rᵢ of the battery is less than the first preset short circuit resistance, that an internal short circuit exists in the battery.

In this embodiment, in order to determine the severity level of the internal short circuit of the battery, the determining, if the internal short circuit resistance Rᵢ of the battery is less than the first preset short circuit resistance, that an internal short circuit exists in the battery includes:
determining, if the internal short circuit resistance Rᵢ of the battery is less than the first preset short circuit resistance or equal to a second preset short circuit resistance, that the internal short circuit in the battery is slight;
determining, if the internal short circuit resistance Rᵢ of the battery is less than the second preset short circuit resistance and greater than or equal to a third preset short circuit resistance, that the internal short circuit in the battery is moderate; and
determining, if the internal short circuit resistance Rᵢ of the battery is less than the third preset short circuit resistance, that the internal short circuit in the battery is severe.

Preferably, the second preset short circuit resistance may be 100 ohms, or other values such as 80 ohms, 90 ohms, 110 ohms, or 120 ohms, depending on specific needs. Preferably, the third preset short circuit resistance may be 10 ohms, or other values such as 8 ohms, 9 ohms, 11 ohms, or 12 ohms, depending on specific needs.

In this embodiment, in order to handle the internal short circuit, the method further includes:
sending, if it is determined that the internal short circuit of the battery is slight, a level-three internal-short-circuit alarm to the user;
sending, if it is determined that the internal short circuit of the battery is moderate, a level-two internal-short-circuit alarm to the user, and limiting an output power of the battery; and
sending, if it is determined that the internal short circuit of the battery is severe, a level-one internal-short-circuit alarm to the user, and cutting off a charge-and-discharge circuit of the battery.

In this application, the internal short circuit resistance Rᵢ of the battery is determined based on the battery-charging standard parameter, the voltage V₀, the voltage difference ΔV, and the charge current I, and whether an internal short circuit exists in the battery is determined based on the internal short circuit resistance Rᵢ of the battery. In this way, during charging of a stand-alone battery, whether an internal short circuit exists in the battery is determined by detecting the internal short circuit resistance of the stand-alone battery. The method satisfies an application scenario in which a portable electronic device is frequently charged and discharged.

Still referring to FIG. 1, in this embodiment, the memory 11 may be an internal memory of the electronic device, that is, a memory built in the electronic device. In other embodiments, the memory 11 may be an external memory of the electronic device, that is, a memory externally connected to the electronic device.

In some embodiments, the memory 11 is configured to store program code and various data, and access the programs or data automatically at a high speed during operation of the electronic device.

The memory 11 may include a random access memory, and may further include a non-volatile memory, such as a hard disk, an internal memory, a plug-in hard disk, a smart media card (Smart Media Card, SMC), a secure digital (Secure Digital, SD) card, a flash card (Flash Card), at least one disk storage device, a flash memory device, or other volatile solid-state storage devices.

In an embodiment, the processor 12 may be a central processing unit (Central Processing Unit, CPU), or may be another general-purpose processor, a digital signal processor (Digital Signal Processor, DSP), an application-specific integrated circuit (Application Specific Integrated Circuit, ASIC), a field programmable gate array (Field-Programmable Gate Array, FPGA), or another programmable logical device, a discrete gate, or a transistor logical device, a discrete hardware component, or the like. The general-purpose processor may be a microprocessor, or the processor may be any other conventional processor or the like.

The program code and various data in the memory 11, when implemented in the form of a software functional unit and sold or used as an independent product, may be stored in a computer-readable storage medium. Based on such an understanding, all or part of the processes of the method described in the foregoing embodiments, for example, the steps of the battery voltage difference update method or the charge estimation method according to this application, may be performed by relevant hardware instructed by a computer program. The computer program may be stored in a computer-readable storage medium. When executed by a processor, the computer program can perform the steps in each method embodiment described above. The computer program includes computer program code. The computer program code may be in the form of source code, object code, an executable file, or some intermediate forms, or the like. The computer-readable medium may include any entity or device capable of carrying the computer program code, record medium, USB disk, mobile hard disk, magnetic disk, optical disk, computer memory, read-only memory (ROM, Read-Only Memory), and the like.

Understandably, the division into the modules is a logical function division, and may be in other division forms in actual implementation. In addition, function modules in each embodiment of this application may be integrated into one processing unit, or each module may exist physically alone, or two or more modules may be integrated into one unit. The integrated module may be implemented in the form of hardware, or may be implemented in the form of hardware plus a software function module.

To a person skilled in the art, it is evident that this application is not limited to the details of the exemplary embodiments described above, and this application can be implemented in other specific forms without departing from the scope of the appended claims.

Therefore, the foregoing embodiments of this application are construed in all respects as exemplary but not restrictive. The scope of this application is defined by the claims appended hereto rather than the foregoing description. Therefore, all changes that fall within the meanings and scope of the claims are intended to be incorporated in this application.

## Claims

1. A method for detecting an internal-short-circuit in a battery, the method comprising:
obtaining a battery-charging standard parameter (S21);
obtaining a voltage V₀ of the battery when the battery enters a constant-current charging phase (S22);
obtaining a voltage difference ΔV generated across a charging time frame Δt during constant-current charging of the battery (S23);
obtaining a charge current I when the battery has been charged for the time frame Δt (524);
**characterised in that** the method further comprises:
determining an internal short circuit resistance Rᵢ of the battery based on the battery-charging standard parameter, the voltage V₀, the voltage difference ΔV, and the charge current I (S25); and
determining, based on the internal short circuit resistance Rᵢ of the battery, whether the internal short circuit exists in the battery (S26),
wherein the obtaining a battery-charging standard parameter comprises:
obtaining the battery-charging standard parameter through an equivalent circuit model of the battery;
before the obtaining the battery-charging standard parameter through the equivalent circuit model of the battery, the method further comprises:
obtaining a first standard voltage difference equation that comprises a standard parameter equation of the battery, wherein the first standard voltage difference equation is obtained through the equivalent circuit model of the battery (S41);
obtaining each standard voltage difference of the battery generated across the charging time frame Δt during the charging performed at different standard charge currents under different numbers of cycles (S42); and
determining the battery-charging standard parameter based on the first standard voltage difference equation and each standard voltage difference of the battery generated across the charging time frame Δt during the charging performed at different standard charge currents under different numbers of cycles, wherein the battery-charging standard parameter is obtained through the equivalent circuit model of the battery (S43);
the battery-charging standard parameter comprises a first battery-charging standard parameter and a second battery-charging standard parameter, and the first standard voltage difference equation comprises: $Δ {V}_{standard} = {αI}_{standard} - αβ ,$
wherein, $α = {R}_{s} \left({e}^{- \frac{{t}_{1}}{{R}_{s} {C}_{s}}}-{e}^{- \frac{{t}_{2}}{{R}_{s} {C}_{s}}}\right)$, and $β = \frac{{U}_{s 0}}{{R}_{s}}$,
wherein, t₂ = t₁ + Δt, ΔV_{standard} is a standard voltage difference generated when the battery has been charged for the time frame Δt, I_{standard} is a standard charge current when the battery has been charged for the time frame Δt, α is the first battery-charging standard parameter, Rₛ is a polarizing internal resistance of the battery, t₁ is a first constant-current charging time point, Cₛ is a polarization capacitance of the battery, t₂ is a second constant-current charging time point, β is the second battery-charging standard parameter, and Uₛ₀ is an initial component voltage value of a polarization capacitor of the battery in a statically standing state.

2. The method according to claim 1, **characterized in that**,
the obtaining a voltage difference ΔV generated across a charging time frame Δt during constant-current charging of the battery comprises:
obtaining a voltage V₁ of the battery at a constant-current charging time point t₁;
obtaining a voltage V₂ of the battery at a constant-current charging time point t₂, wherein t₂ = t₁ + Δt; and
determining the voltage difference ΔV based on the voltage V₁ and the voltage V₂; and
the obtaining a charge current I when the battery has been charged for the time frame Δt comprises:
obtaining a charge current I of the battery in a time frame from the time point t₁ to the time point t₂.

3. The method according to claim 1 or 2, **characterized in that**, before the obtaining a first standard voltage difference equation that comprises a standard parameter equation of the battery, wherein the first standard voltage difference equation is obtained through the equivalent circuit model of the battery, the method further comprises:
determining a standard equation of the equivalent circuit model of the battery based on a capacitance definition formula and a current definition formula;
determining, based on the standard equation of the equivalent circuit model of the battery, a second standard voltage difference equation generated when the battery has been charged for the time frame Δt; and
determining the first standard voltage difference equation based on the second standard voltage difference equation.

4. The method according to claim 3, **characterized in that**, the standard equation of the equivalent circuit model of the battery comprises: ${V}_{standard} = {U}_{oc} + {U}_{s 0} {e}^{- \frac{t}{{R}_{s} {C}_{s}}} + {R}_{s} {I}_{standard} \left(1-{e}^{- \frac{t}{{R}_{s} {C}_{s}}}\right) + {I}_{standard} {R}_{0} ,$ wherein, V_{standard} is a standard voltage of the battery, U_{oc} is an open circuit voltage of the battery, Uₛ₀ is an initial component voltage value of a polarization capacitor of the battery in a statically standing state, t is a charging time length of the battery, Rₛ is a polarizing internal resistance of the battery, Cₛ is a polarization capacitance of the battery, I_{standard} is a standard charge current of the battery, and R₀ is an ohmic internal resistance of the battery.

5. The method according to claim 1, **characterized in that**, the determining an internal short circuit resistance Rᵢ of the battery based on the battery-charging standard parameter, the voltage V₀, the voltage difference ΔV, and the charge current I comprises:
determining a first equation of an equivalent circuit model of the battery based on a capacitance definition formula and a current definition formula;
determining, based on the first equation of the equivalent circuit model of the battery, a voltage difference equation generated when the battery has been charged for the time frame Δt; and
determining an internal short circuit resistance Rᵢ of the battery based on the voltage difference equation, the battery-charging standard parameter, the voltage V₀, the voltage difference ΔV, and the charge current I.

6. The method according to claim 5, **characterized in that**, the first equation of the equivalent circuit model of the battery comprises: $V = {IR}_{s} + {IR}_{0} + {U}_{oc} - {R}_{s} \left(I-\frac{{U}_{s 0}}{{R}_{s}}+\frac{{V}_{0}}{{R}_{i}}\right) {e}^{- \frac{t}{{R}_{s} {C}_{s}}} ,$ wherein, V is a voltage of the battery, I is the charge current when the battery has been charged for the time frame Δt, Rₛ is a polarizing internal resistance of the battery, R₀ is an ohmic internal resistance of the battery, U_{oc} is an open circuit voltage of the battery, Uₛ₀ is an initial component voltage value of a polarization capacitor of the battery in a statically standing state, V₀ is a voltage of the battery when the battery enters the constant-current charging phase, and Rᵢ is an internal short circuit resistance of the battery.

7. The method according to claim 5, **characterized in that**, the determining a first equation of an equivalent circuit model of the battery based on a capacitance definition formula and a current definition formula comprises:
creating the equivalent circuit model of the battery;
determining a second equation of the equivalent circuit model of the battery based on the Ohm's law and the Kirchhoff's law; and
determining the first equation of the equivalent circuit model of the battery based on the capacitance definition formula, the current definition formula, and the second equation of the equivalent circuit model of the battery.

8. The method according to claim 7, **characterized in that**, the determining the first equation of the equivalent circuit model of the battery based on the capacitance definition formula, the current definition formula, and the second equation of the equivalent circuit model of the battery comprises:
determining a differential equation of a component voltage of a polarization capacitor of the battery based on the capacitance definition formula and the current definition formula;
solving the differential equation of the component voltage of the polarization capacitor of the battery to determine a general solution to the component voltage of the polarization capacitor of the battery; and
determining the first equation of the equivalent circuit model of the battery based on the second equation of the equivalent circuit model of the battery and the general solution to the component voltage of the polarization capacitor of the battery.

9. The method according to claim 8, **characterized in that**,
the differential equation of the component voltage of the polarization capacitor of the battery comprises: ${C}_{s} \frac{{dU}_{s}}{dt} + \frac{{U}_{s}}{{R}_{s}} = I - \frac{V}{{R}_{i}} ,$
wherein, Cₛ is a polarization capacitance of the battery, Uₛ is the component voltage of the polarization capacitor of the battery, Rₛ is a polarizing internal resistance of the battery, I is a charge current when the battery has been charged for the time frame Δt, V is a voltage of the battery, and Rᵢ is an internal-short-circuit resistance of the battery; and
the general solution to the component voltage of the polarization capacitor of the battery comprises: ${U}_{s} = \left({U}_{s 0}-\frac{{V}_{0}}{{R}_{i}}{R}_{s}\right) {e}^{- \frac{t}{{R}_{s} {C}_{s}}} + {R}_{s} \left(I-\frac{V}{{R}_{i}}\right) \left(1-{e}^{- \frac{t}{{R}_{s} {C}_{s}}}\right) ,$
wherein, Uₛ is the component voltage of the polarization capacitor of the battery, Uₛ₀ is an initial component voltage value of the polarization capacitor of the battery in a statically standing state, V₀ is the voltage of the battery when the battery enters the constant-current charging phase, Rᵢ is the internal short circuit resistance of the battery, Rₛ is the polarizing internal resistance of the battery, t is a charging time length of the battery, Cₛ is the polarization capacitance of the battery, I is the charge current when the battery has been charged for the time frame Δt, and V is the voltage of the battery.

10. The method according to claim 5, **characterized in that**,
before the determining an internal short circuit resistance Rᵢ of the battery based on the voltage difference equation, the battery-charging standard parameter, the voltage V₀, the voltage difference ΔV, and the charge current I, the method further comprises:
obtaining a standard parameter equation of the battery, wherein the standard parameter equation is obtained through the equivalent circuit model of the battery; and
the determining an internal short circuit resistance Rᵢ of the battery based on the voltage difference equation, the battery-charging standard parameter, the voltage V₀, the voltage difference ΔV, and the charge current I comprises:
determining an internal short circuit resistance equation of the battery based on the voltage difference equation and the standard parameter equation of the battery; and
determining the internal short circuit resistance Rᵢ of the battery based on the internal short circuit resistance equation of the battery, the battery-charging standard parameter, the voltage V₀, the voltage difference ΔV, and the charge current I.

11. The method according to claim 10, **characterized in that**, the battery-charging standard parameter comprises a first battery-charging standard parameter and a second battery-charging standard parameter, and the internal short circuit resistance equation of the battery comprises: ${R}_{i} = \frac{{V}_{0}}{\frac{ΔV}{α} - I + β} ,$ wherein, Rᵢ is the internal short circuit resistance of the battery, V₀ is a voltage of the battery when the battery enters the constant-current charging phase, ΔV is the voltage difference generated across the charging time frame Δt during constant-current charging of the battery, α is the first battery-charging standard parameter, β is the second battery-charging standard parameter, and I is the charging current when the battery has been charged for the time frame Δt.

12. An electronic device (100), comprising:
a battery (13);
a processor (12); and
a memory (11), wherein the memory (11) stores a plurality of program modules, and **characterised in that**
the plurality of program modules are loaded by the processor (12) and execute the battery (13) internal-short-circuit detection method according to any one of claims 1 to 11.

13. A storage medium on which at least one computer instruction is stored, **characterized in that**, the at least one computer instruction is loaded by a processor (12) to execute the battery (13) internal-short-circuit detection method according to any one of claims 1 to 11.

## Patentansprüche

1. Verfahren zur Erkennung eines internen Kurzschlusses in einer Batterie, wobei das Verfahren umfasst:
Ermitteln eines Batterieladestandardparameters (S21);
Ermitteln einer Spannung V₀ der Batterie, wenn die Batterie in eine Konstantstrom-Ladephase eintritt (S22);
Ermitteln einer Spannungsdifferenz ΔV, die über einen Ladezeitraum Δt während des Konstantstromladens der Batterie erzeugt wird (S23);
Ermitteln eines Ladestroms I, wenn die Batterie über den Zeitraum Δt geladen worden ist (S24);
**dadurch gekennzeichnet, dass** das Verfahren ferner umfasst:
Bestimmen eines internen Kurzschlusswiderstands Rᵢ der Batterie auf Grundlage des Batterieladestandardparameters, der Spannung V₀, der Spannungsdifferenz ΔV und des Ladestroms I (S25); und
Bestimmen, auf Grundlage des internen Kurzschlusswiderstands Rᵢ der Batterie, ob der interne Kurzschluss in der Batterie vorliegt (S26),
wobei das Ermitteln eines Batterieladestandardparameters umfasst:
Ermitteln des Batterieladestandardparameters über ein Ersatzschaltbildmodell der Batterie;
wobei das Verfahren vor dem Ermitteln des Batterieladestandardparameters über das Ersatzschaltbildmodell der Batterie ferner umfasst:
Ermitteln einer ersten Standardspannungsdifferenzgleichung, die eine Standardparametergleichung der Batterie umfasst, wobei die erste Standardspannungsdifferenzgleichung über das Ersatzschaltbildmodell der Batterie ermittelt wird (S41);
Ermitteln jeder Standardspannungsdifferenz der Batterie, die über den Ladezeitraum Δt während des Ladens erzeugt wird, das bei verschiedenen Standardladeströmen und bei verschiedenen Zyklenzahlen durchgeführt wird (S42); und
Bestimmen des Batterieladestandardparameters auf Grundlage der ersten Standardspannungsdifferenzgleichung und jeder Standardspannungsdifferenz der Batterie, die über den Ladezeitraum Δt während des Ladens erzeugt wird, das bei verschiedenen Standardladeströmen und bei verschiedenen Zyklenzahlen durchgeführt wird, wobei der Batterieladestandardparameter über das Ersatzschaltbildmodell der Batterie ermittelt wird (S43);
der Batterieladestandardparameter umfasst einen ersten Batterieladestandardparameter und einen zweiten Batterieladestandardparameter, und die erste Standardspannungsdifferenzgleichung umfasst: $Δ {V}_{standard} = {αI}_{standard} - αβ$
wobei $α = {R}_{s} \left({e}^{- \frac{{t}_{1}}{{R}_{s} {C}_{s}}}-{e}^{- \frac{{t}_{2}}{{R}_{s} {C}_{s}}}\right) und β = \frac{{U}_{s 0}}{{R}_{s}}$
wobei t₂ = t₁ + Δt, ΔV_{standard} eine Standardspannungsdifferenz ist, die erzeugt wird, wenn die Batterie über den Zeitraum Δt geladen worden ist, I_{standard} ein Standardladestrom ist, wenn die Batterie über den Zeitraum Δt geladen worden ist, α der erste Batterieladestandardparameter ist, Rₛ ein Polarisationsinnenwiderstand der Batterie ist, t₁ ein erster Konstantstrom-Ladezeitpunkt ist, Cₛ eine Polarisationskapazität der Batterie ist, t₂ ein zweiter Konstantstrom-Ladezeitpunkt ist, β der zweite Batterieladestandardparameter ist und Uₛ₀ ein Anfangswert der Komponentenspannung eines Polarisationskondensators der Batterie in einem statischen Ruhezustand ist.

2. Verfahren nach Anspruch 1, **dadurch gekennzeichnet, dass** das Ermitteln einer Spannungsdifferenz ΔV, die über einen Ladezeitraum Δt während des Konstantstromladens der Batterie erzeugt wird, umfasst:
Ermitteln einer Spannung V₁ der Batterie zu einem Konstantstrom-Ladezeitpunkt t₁;
Ermitteln einer Spannung V₂ der Batterie zu einem Konstantstrom-Ladezeitpunkt t₂, wobei t₂ = t₁ + Δt; und
Bestimmen der Spannungsdifferenz ΔV auf Grundlage der Spannung V₁ und der Spannung V₂; und
das Ermitteln eines Ladestroms I, wenn die Batterie über den Zeitraum Δt geladen worden ist, umfasst:
Ermitteln eines Ladestroms I der Batterie in einem Zeitraum von dem Zeitpunkt t₁ bis zu dem Zeitpunkt t₂.

3. Verfahren nach Anspruch 1 oder 2, **dadurch gekennzeichnet, dass** das Verfahren vor dem Ermitteln einer ersten Standardspannungsdifferenzgleichung, die eine Standardparametergleichung der Batterie umfasst, wobei die erste Standardspannungsdifferenzgleichung über das Ersatzschaltbildmodell der Batterie ermittelt wird, ferner umfasst:
Bestimmen einer Standardgleichung des Ersatzschaltbildmodells der Batterie auf Grundlage einer Formel zur Definition der Kapazität und einer Formel zur Definition des Stroms;
Bestimmen, auf Grundlage der Standardgleichung des Ersatzschaltbildmodells der Batterie, einer zweiten Standardspannungsdifferenzgleichung, die erzeugt wird, wenn die Batterie über den Zeitraum Δt geladen worden ist; und
Bestimmen der ersten Standardspannungsdifferenzgleichung auf Grundlage der zweiten Standardspannungsdifferenzgleichung.

4. Verfahren nach Anspruch 3, **dadurch gekennzeichnet, dass** die Standardgleichung des Ersatzschaltbildmodells der Batterie umfasst: ${V}_{standard} = {U}_{oc} + {U}_{s 0} {e}^{- \frac{t}{{R}_{s} {C}_{s}}} + {R}_{s} {I}_{standard} \left(1-{e}^{- \frac{t}{{R}_{s} {C}_{s}}}\right) + {I}_{standard} {R}_{0}$ wobei V_{standard} eine Standardspannung der Batterie ist, U_{oc} eine Leerlaufspannung der Batterie ist, Uₛ₀ ein Anfangswert der Komponentenspannung eines Polarisationskondensators der Batterie in einem statischen Ruhezustand ist, t eine Ladezeitdauer der Batterie ist, Rₛ ein Polarisationsinnenwiderstand der Batterie ist, Cₛ eine Polarisationskapazität der Batterie ist, I_{standard} ein Standardladestrom der Batterie ist und R₀ ein ohmscher Innenwiderstand der Batterie ist.

5. Verfahren nach Anspruch 1, **dadurch gekennzeichnet, dass** das Bestimmen eines internen Kurzschlusswiderstands Rᵢ der Batterie auf Grundlage des Batterieladestandardparameters, der Spannung V₀, der Spannungsdifferenz ΔV und des Ladestroms I umfasst:
Bestimmen einer ersten Gleichung eines Ersatzschaltbildmodells der Batterie auf Grundlage einer Formel zur Definition der Kapazität und einer Formel zur Definition des Stroms;
Bestimmen, auf Grundlage der ersten Gleichung des Ersatzschaltbildmodells der Batterie, einer Spannungsdifferenzgleichung, die erzeugt wird, wenn die Batterie über den Zeitraum Δt geladen worden ist; und
Bestimmen eines internen Kurzschlusswiderstands Rᵢ der Batterie auf Grundlage der Spannungsdifferenzgleichung, des Batterieladestandardparameters, der Spannung V₀, der Spannungsdifferenz ΔV und des Ladestroms I.

6. Verfahren nach Anspruch 5, **dadurch gekennzeichnet, dass** die erste Gleichung des Ersatzschaltbildmodells der Batterie umfasst: $V = {IR}_{s} + {IR}_{0} + {U}_{oc} - {R}_{s} \left(I-\frac{{U}_{s 0}}{{R}_{s}}+\frac{{V}_{0}}{{R}_{i}}\right) {e}^{- \frac{t}{{R}_{s} {C}_{s}}}$ wobei V eine Spannung der Batterie ist, I der Ladestrom ist, wenn die Batterie über den Zeitraum Δt geladen worden ist, Rₛ ein Polarisationsinnenwiderstand der Batterie ist, R₀ ein ohmscher Innenwiderstand der Batterie ist, U_{oc} eine Leerlaufspannung der Batterie ist, Uₛ₀ ein Anfangswert der Komponentenspannung eines Polarisationskondensators der Batterie in einem statischen Ruhezustand ist, V₀ eine Spannung der Batterie ist, wenn die Batterie in die Konstantstrom-Ladephase eintritt, und Rᵢ ein interner Kurzschlusswiderstand der Batterie ist.

7. Verfahren nach Anspruch 5, **dadurch gekennzeichnet, dass** das Bestimmen einer ersten Gleichung eines Ersatzschaltbildmodells der Batterie auf Grundlage einer Formel zur Definition der Kapazität und einer Formel zur Definition des Stroms umfasst:
Erstellen des Ersatzschaltbildmodells der Batterie;
Bestimmen einer zweiten Gleichung des Ersatzschaltbildmodells der Batterie auf Grundlage des Ohmschen Gesetzes und des Kirchhoffschen Gesetzes; und
Bestimmen der ersten Gleichung des Ersatzschaltbildmodells der Batterie auf Grundlage der Formel zur Definition der Kapazität, der Formel zur Definition des Stroms und der zweiten Gleichung des Ersatzschaltbildmodells der Batterie.

8. Verfahren nach Anspruch 7, **dadurch gekennzeichnet, dass** das Bestimmen der ersten Gleichung des Ersatzschaltbildmodells der Batterie auf Grundlage der Formel zur Definition der Kapazität, der Formel zur Definition des Stroms und der zweiten Gleichung des Ersatzschaltbildmodells der Batterie umfasst:
Bestimmen einer Differentialgleichung einer Komponentenspannung eines Polarisationskondensators der Batterie auf Grundlage der Formel zur Definition der Kapazität und der Formel zur Definition des Stroms;
Lösen der Differentialgleichung der Komponentenspannung des Polarisationskondensators der Batterie, um eine allgemeine Lösung für die Komponentenspannung des Polarisationskondensators der Batterie zu bestimmen; und
Bestimmen der ersten Gleichung des Ersatzschaltbildmodells der Batterie auf Grundlage der zweiten Gleichung des Ersatzschaltbildmodells der Batterie und der allgemeinen Lösung für die Komponentenspannung des Polarisationskondensators der Batterie.

9. Verfahren nach Anspruch 8, **dadurch gekennzeichnet, dass**
die Differentialgleichung der Komponentenspannung des Polarisationskondensators der Batterie umfasst: ${C}_{s} \frac{{dU}_{s}}{dt} + \frac{{U}_{s}}{{R}_{s}} = I - \frac{V}{{R}_{i}}$
wobei Cₛ eine Polarisationskapazität der Batterie ist, Uₛ die Komponentenspannung des Polarisationskondensators der Batterie ist, Rₛ ein Polarisationsinnenwiderstand der Batterie ist, I ein Ladestrom ist, wenn die Batterie über den Zeitraum Δt geladen worden ist, V eine Spannung der Batterie ist und Rᵢ ein interner Kurzschlusswiderstand der Batterie ist; und
die allgemeine Lösung für die Komponentenspannung des Polarisationskondensators der Batterie umfasst: ${U}_{s} = \left({U}_{s 0}-\frac{{V}_{0}}{{R}_{i}}{R}_{s}\right) {e}^{- \frac{t}{{R}_{s} {C}_{s}}} + {R}_{s} \left(I-\frac{V}{{R}_{i}}\right) \left(1-{e}^{- \frac{t}{{R}_{s} {C}_{s}}}\right)$
wobei Uₛ die Komponentenspannung des Polarisationskondensators der Batterie ist, Uₛ₀ ein Anfangswert der Komponentenspannung des Polarisationskondensators der Batterie in einem statischen Ruhezustand ist, V₀ die Spannung der Batterie ist, wenn die Batterie in die Konstantstrom-Ladephase eintritt, Rᵢ der interne Kurzschlusswiderstand der Batterie ist, Rₛ der Polarisationsinnenwiderstand der Batterie ist, t eine Ladezeitdauer der Batterie ist, Cₛ die Polarisationskapazität der Batterie ist, I der Ladestrom ist, wenn die Batterie über den Zeitraum Δt geladen worden ist, und V die Spannung der Batterie ist.

10. Verfahren nach Anspruch 5, **dadurch gekennzeichnet, dass**
das Verfahren vor dem Bestimmen eines internen Kurzschlusswiderstands Rᵢ der Batterie auf Grundlage der Spannungsdifferenzgleichung, des Batterieladestandardparameters, der Spannung V₀, der Spannungsdifferenz ΔV und des Ladestroms I ferner umfasst:
Ermitteln einer Standardparametergleichung der Batterie, wobei die Standardparametergleichung über das Ersatzschaltbildmodell der Batterie ermittelt wird; und
das Bestimmen eines internen Kurzschlusswiderstands Rᵢ der Batterie auf Grundlage der Spannungsdifferenzgleichung, des Batterieladestandardparameters, der Spannung V₀, der Spannungsdifferenz ΔV und des Ladestroms I umfasst:
Bestimmen einer Gleichung für den internen Kurzschlusswiderstand der Batterie auf Grundlage der Spannungsdifferenzgleichung und der Standardparametergleichung der Batterie; und
Bestimmen des internen Kurzschlusswiderstands Rᵢ der Batterie auf Grundlage der Gleichung für den internen Kurzschlusswiderstand der Batterie, des Batterieladestandardparameters, der Spannung V₀, der Spannungsdifferenz ΔV und des Ladestroms I.

11. Verfahren nach Anspruch 10, **dadurch gekennzeichnet, dass** der Batterieladestandardparameter einen ersten Batterieladestandardparameter und einen zweiten Batterieladestandardparameter umfasst und die Gleichung für den internen Kurzschlusswiderstand der Batterie umfasst: ${R}_{i} = \frac{{V}_{0}}{\frac{Δ V}{α} - I + β}$ wobei Rᵢ der interne Kurzschlusswiderstand der Batterie ist, V₀ eine Spannung der Batterie ist, wenn die Batterie in die Konstantstrom-Ladephase eintritt, ΔV die Spannungsdifferenz ist, die über den Ladezeitraum Δt während des Konstantstromladens der Batterie erzeugt wird, α der erste Batterieladestandardparameter ist, β der zweite Batterieladestandardparameter ist und I der Ladestrom ist, wenn die Batterie über den Zeitraum Δt geladen worden ist.

12. Elektronische Vorrichtung (100), umfassend:
eine Batterie (13);
einen Prozessor (12); und
einen Speicher (11), wobei der Speicher (11) eine Vielzahl von Programmmodulen speichert, und **dadurch gekennzeichnet, dass**
die Vielzahl von Programmmodulen von dem Prozessor (12) geladen werden und das Verfahren zur Erkennung eines internen Kurzschlusses der Batterie (13) nach einem der Ansprüche 1 bis 11 ausführen.

13. Speichermedium, auf dem mindestens eine Computeranweisung gespeichert ist, **dadurch gekennzeichnet, dass** die mindestens eine Computeranweisung von einem Prozessor (12) geladen wird, um das Verfahren zur Erkennung eines internen Kurzschlusses der Batterie (13) nach einem der Ansprüche 1 bis 11 auszuführen.

## Revendications

1. Procédé de détection d'un court-circuit interne dans une batterie, le procédé comprenant :
la détermination d'un paramètre standard de charge de batterie (S21) ;
la détermination d'une tension V0 de la batterie lorsque celle-ci entre dans une phase de charge à courant constant (S22) ;
la détermination d'une différence de tension ΔV, générée sur une durée de charge Δt pendant la charge à courant constant de la batterie (S23) ;
la détermination d'un courant de charge I, lorsque la batterie a été chargée pendant la période Δt (S24) ;
**caractérisé en ce que** le procédé comprend en outre :
la détermination d'une résistance de court-circuit interne Ri de la batterie sur la base du paramètre standard de charge de batterie, de la tension V0, de la différence de tension ΔV et du courant de charge I (S25) ; et
la détermination, sur la base de la résistance de court-circuit interne Ri de la batterie, de la présence ou non d'un court-circuit interne dans la batterie (S26),
dans lequel la détermination d'un paramètre standard de charge de batterie comprend :
la détermination du paramètre standard de charge de batterie via un modèle de circuit équivalent de la batterie ;
dans lequel le procédé comprend en outre, avant la détermination du paramètre standard de charge de batterie via le modèle de circuit équivalent de la batterie :
la détermination d'une première équation de différence de tension standard incluant une équation de paramètre standard de la batterie, la première équation de différence de tension standard étant déterminée via le modèle de circuit équivalent de la batterie (S41) ;
la détermination de chaque différence de tension standard de la batterie, générée sur la durée de charge Δt pendant la charge effectuée à différents courants de charge standards et à différents nombres de cycles (S42) ; et
la détermination du paramètre standard de charge de batterie sur la base de la première équation de différence de tension standard et de chaque différence de tension standard de la batterie, générée sur la durée de charge Δt pendant la charge effectuée à différents courants de charge standards et à différents nombres de cycles, le paramètre standard de charge de batterie étant déterminé via le modèle de circuit équivalent de la batterie (S43) ;
le paramètre standard de charge de batterie comprend un premier paramètre standard de charge de batterie et un deuxième paramètre standard de charge de batterie, et la première équation de différence de tension standard comprend : $Δ {V}_{standard} = {αI}_{standard} - αβ$ dans lequel $α = {R}_{s} \left({e}^{- \frac{{t}_{1}}{{R}_{s} {C}_{s}}}-{e}^{- \frac{{t}_{2}}{{R}_{s} {C}_{s}}}\right) und β = \frac{{U}_{s 0}}{{R}_{s}}$
dans lequel t2 = t1 + Δt, ΔVstandard est une différence de tension standard générée lorsque la batterie a été chargée pendant la période Δt, Istandard est un courant de charge standard lorsque la batterie a été chargée pendant la période Δt, α est le premier paramètre standard de charge de batterie, Rs est une résistance interne de polarisation de la batterie, t1 est un premier instant de charge à courant constant, Cs est une capacité de polarisation de la batterie, t2 est un deuxième instant de charge à courant constant, β est le deuxième paramètre standard de charge de batterie et Us0 est une valeur initiale de la composante de tension d'un condensateur de polarisation de la batterie dans un état de repos statique.

2. Procédé selon la revendication 1, **caractérisé en ce que**
la détermination d'une différence de tension ΔV, générée sur une durée de charge Δt pendant la charge à courant constant de la batterie, comprend :
la détermination d'une tension V1 de la batterie à un instant de charge à courant constant t1 ;
la détermination d'une tension V2 de la batterie à un instant de charge à courant constant t2, où t2 = t1 + Δt ; et
la détermination de la différence de tension ΔV sur la base des tensions V1 et V2 ; et
la détermination d'un courant de charge I, lorsque la batterie a été chargée pendant la période Δt, comprend :
la détermination d'un courant de charge I de la batterie dans une période allant du temps t1 au temps t2.

3. Procédé selon la revendication 1 ou 2, **caractérisé en ce que** le procédé comprend, avant la détermination d'une première équation de différence de tension standard incluant une équation de paramètre standard de la batterie, ladite première équation de différence de tension standard étant déterminée via le modèle de circuit équivalent de la batterie, en outre :
la détermination d'une équation standard du modèle de circuit équivalent de la batterie sur la base d'une formule de définition de la capacité et d'une formule de définition du courant ;
la détermination, sur la base de l'équation standard du modèle de circuit équivalent de la batterie, d'une deuxième équation de différence de tension standard, générée lorsque la batterie a été chargée pendant la période Δt ; et
la détermination de la première équation de différence de tension standard sur la base de la deuxième équation de différence de tension standard.

4. Procédé selon la revendication 3, **caractérisé en ce que** l'équation standard du modèle de circuit équivalent de la batterie comprend : ${V}_{standard} = {U}_{oc} + {U}_{s 0} {e}^{- \frac{t}{{R}_{s} {C}_{s}}} + {R}_{s} {I}_{standard} \left(1-{e}^{- \frac{t}{{R}_{s} {C}_{s}}}\right) + {I}_{standard} {R}_{0}$ dans lequel Vstandard est une tension standard de la batterie, Uoc est une tension à vide de la batterie, Us0 est une valeur initiale de la composante de tension d'un condensateur de polarisation de la batterie dans un état de repos statique, t est une durée de charge de la batterie, Rs est une résistance interne de polarisation de la batterie, Cs est une capacité de polarisation de la batterie, Istandard est un courant de charge standard de la batterie et R0 est une résistance interne ohmique de la batterie.

5. Procédé selon la revendication 1, **caractérisé en ce que** la détermination d'une résistance de court-circuit interne Ri de la batterie sur la base du paramètre standard de charge de batterie, de la tension V0, de la différence de tension ΔV et du courant de charge I comprend :
la détermination d'une première équation d'un modèle de circuit équivalent de la batterie sur la base d'une formule de définition de la capacité et d'une formule de définition du courant ;
la détermination, sur la base de la première équation du modèle de circuit équivalent de la batterie, d'une équation de différence de tension, générée lorsque la batterie a été chargée pendant la période Δt ; et
la détermination d'une résistance de court-circuit interne Ri de la batterie sur la base de l'équation de différence de tension, du paramètre standard de charge de batterie, de la tension V0, de la différence de tension ΔV et du courant de charge I.

6. Procédé selon la revendication 5, **caractérisé en ce que** la première équation du modèle de circuit équivalent de la batterie comprend : $V = {IR}_{s} + {IR}_{0} + {U}_{oc} - {R}_{s} \left(I-\frac{{U}_{s 0}}{{R}_{s}}+\frac{{V}_{0}}{{R}_{i}}\right) {e}^{- \frac{t}{{R}_{s} {C}_{s}}}$ dans lequel V est une tension de la batterie, I est le courant de charge lorsque la batterie a été chargée pendant la période Δt, Rs est une résistance interne de polarisation de la batterie, R0 est une résistance interne ohmique de la batterie, Uoc est une tension à vide de la batterie, Us0 est une valeur initiale de la composante de tension d'un condensateur de polarisation de la batterie dans un état de repos statique, V0 est une tension de la batterie lorsque la batterie entre dans la phase de charge à courant constant, et Ri est une résistance de court-circuit interne de la batterie.

7. Procédé selon la revendication 5, **caractérisé en ce que** la détermination d'une première équation d'un modèle de circuit équivalent de la batterie sur la base d'une formule de définition de la capacité et d'une formule de définition du courant comprend :
la création du modèle de circuit équivalent de la batterie ;
la détermination d'une deuxième équation du modèle de circuit équivalent de la batterie sur la base de la loi d'Ohm et de la loi de Kirchhoff ; et
la détermination de la première équation du modèle de circuit équivalent de la batterie sur la base de la formule de définition de la capacité, de la formule de définition du courant et de la deuxième équation du modèle de circuit équivalent de la batterie.

8. Procédé selon la revendication 7, **caractérisé en ce que** la détermination de la première équation du modèle de circuit équivalent de la batterie sur la base de la formule de définition de la capacité, de la formule de définition du courant et de la deuxième équation du modèle de circuit équivalent de la batterie comprend :
la détermination d'une équation différentielle d'une composante de tension d'un condensateur de polarisation de la batterie sur la base de la formule de définition de la capacité et de la formule de définition du courant ;
la résolution de l'équation différentielle de la composante de tension du condensateur de polarisation de la batterie afin de déterminer une solution générale pour la composante de tension du condensateur de polarisation de la batterie ; et
la détermination de la première équation du modèle de circuit équivalent de la batterie sur la base de la deuxième équation du modèle de circuit équivalent de la batterie et de la solution générale pour la composante de tension du condensateur de polarisation de la batterie.

9. Procédé selon la revendication 8, **caractérisé en ce que**
l'équation différentielle de la composante de tension du condensateur de polarisation de la batterie comprend : ${C}_{s} \frac{{dU}_{s}}{dt} + \frac{{U}_{s}}{{R}_{s}} = I - \frac{V}{{R}_{i}}$
dans lequel Cs est une capacité de polarisation de la batterie, Us est la composante de tension du condensateur de polarisation de la batterie, Rs est une résistance interne de polarisation de la batterie, I est un courant de charge lorsque la batterie a été chargée pendant la période Δt, V est une tension de la batterie et Ri est une résistance de court-circuit interne de la batterie ; et
la solution générale pour la composante de tension du condensateur de polarisation de la batterie comprend : ${U}_{s} = \left({U}_{s 0}-\frac{{V}_{0}}{{R}_{i}}{R}_{s}\right) {e}^{- \frac{t}{{R}_{s} {C}_{s}}} + {R}_{s} \left(I-\frac{V}{{R}_{i}}\right) \left(1-{e}^{- \frac{t}{{R}_{s} {C}_{s}}}\right)$
dans lequel Us est la composante de tension du condensateur de polarisation de la batterie, Us0 est une valeur initiale de la composante de tension du condensateur de polarisation de la batterie dans un état de repos statique, V0 est la tension de la batterie lorsque la batterie entre dans la phase de charge à courant constant, Ri est la résistance de court-circuit interne de la batterie, Rs est la résistance interne de polarisation de la batterie, t est une durée de charge de la batterie, Cs est la capacité de polarisation de la batterie, I est le courant de charge lorsque la batterie a été chargée pendant la période Δt, et V est la tension de la batterie.

10. Procédé selon la revendication 5, **caractérisé en ce que**
le procédé comprend, avant la détermination d'une résistance de court-circuit interne Ri de la batterie sur la base de l'équation de différence de tension, du paramètre standard de charge de batterie, de la tension V0, de la différence de tension ΔV et du courant de charge I, en outre :
la détermination d'une équation de paramètre standard de la batterie, ladite équation de paramètre standard étant déterminée via le modèle de circuit équivalent de la batterie ; et
la détermination d'une résistance de court-circuit interne Ri de la batterie sur la base de l'équation de différence de tension, du paramètre standard de charge de batterie, de la tension V0, de la différence de tension ΔV et du courant de charge I comprend :
la détermination d'une équation pour la résistance de court-circuit interne de la batterie sur la base de l'équation de différence de tension et de l'équation de paramètre standard de la batterie ; et
la détermination de la résistance de court-circuit interne Ri de la batterie sur la base de l'équation de résistance de court-circuit interne de la batterie, du paramètre standard de charge de batterie, de la tension V0, de la différence de tension ΔV et du courant de charge I.

11. Procédé selon la revendication 10, **caractérisé en ce que** le paramètre standard de charge de batterie comprend un premier paramètre standard de charge de batterie et un deuxième paramètre standard de charge de batterie et que l'équation pour la résistance de court-circuit interne de la batterie comprend : ${R}_{i} = \frac{{V}_{0}}{\frac{Δ V}{α} - I + β}$ dans lequel Ri est la résistance de court-circuit interne de la batterie, V0 est une tension de la batterie lorsque la batterie entre dans la phase de charge à courant constant, ΔV est la différence de tension générée sur la durée de charge Δt pendant la charge à courant constant de la batterie, α est le premier paramètre standard de charge de batterie, β est le deuxième paramètre standard de charge de batterie et I est le courant de charge lorsque la batterie a été chargée pendant la période Δt.

12. Dispositif électronique (100), comprenant :
une batterie (13) ;
un processeur (12) ; et
une mémoire (11), la mémoire (11) stockant une pluralité de modules de programme, et **caractérisé en ce que**
la pluralité de modules de programme est chargée par le processeur (12) pour exécuter le procédé de détection d'un court-circuit interne de la batterie (13) selon l'une quelconque des revendications 1 à 11.

13. Support de stockage sur lequel au moins une instruction informatique est stockée, **caractérisé en ce que** la au moins une instruction informatique est chargée par un processeur (12) pour exécuter le procédé de détection d'un court-circuit interne de la batterie (13) selon l'une quelconque des revendications 1 à 11.
